# EUROPÄISCHE PATENTSCHRIFT

(11) **EP 4 432 336 B1**
(45) Veröffentlichungstag und Bekanntmachung des Hinweises auf die Patenterteilung: **18.06.2025**
(21) Anmeldenummer: 23158267.7
(22) Anmeldetag: 23.02.2023
(51) Int. Cl.: H01L 21/677, E04B 9/20, B65G 37/02

(54) **SHUTTLELAGER UND VERFAHREN ZUM HERSTELLEN DESSELBEN**
SHUTTLE STORAGE AND METHOD FOR PRODUCING THE SAME
PALIER DE NAVETTE ET SON PROCÉDÉ DE FABRICATION

(43) Veröffentlichungstag der Anmeldung: 18.09.2024
(73) Patentinhaber: Fabmatics GmbH, 01109 Dresden (DE)
(72) Erfinder: BUDACH, Karsten, 01309 Dresden (DE); ENGEL, Martin, 01097 Dresden (DE); GÜRBIG, Alexander, 01097 Dresden (DE)
(74) Vertreter: Bauer, Dirk

(56) Entgegenhaltungen:
- EP-A1- 2 615 625
- EP-A1- 3 862 297
- DE-A1- 102008 015 472
- DE-U1- 202012 000 143
- KR-A- 20210 133 741
- KR-A- 20210 133 742
- KR-A- 20210 143 566
- KR-B1- 101 915 982
- US-A1- 2022 246 450

## Beschreibung

Die Erfindung betrifft zunächst ein Shuttlelager für Transportboxen für Waferscheiben mit einer horizontal verlaufenden Gasse für ein Lagerfahrzeug, mit einem Linearmotor für das Lagerfahrzeug auf einem Boden der Gasse, mit einer Übergabestation zur Übergabe der Transportboxen in das oder aus dem Shuttlelager, mit einer Haltekonstruktion, die von einer Raumdecke abgehängt ist und mit Lagerplätzen für die Transportboxen, die in einer horizontal verlaufenden Lagerebene entlang der Gasse an der Haltekonstruktion befestigt sind. Die Erfindung betrifft weiter ein Verfahren zum Herstellen eines solchen Shuttlelagers. Solche Shuttlelager, wie sie beispielsweise aus WO 03/046954 A2 bekannt sind, dienen insbesondere zur Lagerung von Waferscheiben in einem Reinraum zur Halbleiterfertigung.

Weiterer Stand der Technik wird in den Dokumenten DE 10 2008 015 472 A1, DE 20 2012 000 143 U1 und KR 10-2021-0143566 offenbart.

Um die Beschädigung der empfindlichen Waferscheiben bei Lagerung und Handhabung zu vermeiden, müssen Lagerplätze und Transportwege exakt zueinander ausgerichtet werden. Der Aufbau des bekannten Shuttlelagers ausgehend von einer typischerweise mit deutlich höheren Toleranzen hergestellten Raumdecke stellt daher hohe Anforderungen an Material, Abläufe und die Fähigkeiten der ausführenden Personen.

### Aufgabe

Der Erfindung liegt die Aufgabe zugrunde, die Herstellung des Shuttlelagers zu vereinfachen.

### Lösung

Ausgehend von dem bekannten Shuttlelager wird nach der Erfindung vorgeschlagen, an der Raumdecke befestigte Deckenelemente, und an den Deckenelementen angebrachte Halteelemente für die Lagerplätze vorzusehen, wobei zum Herstellen des Shuttlelagers zunächst die Deckenelemente an der Raumdecke befestigt und die Halteelemente für die Lagerplätze in einer vertikalen Höhe in der Lagerebene nivelliert und dann die Lagerplätze an den Halteelementen befestigt werden.

In einem "Shuttlelager" wird das Lagergut horizontal in der Gasse durch ein autonomes Lagerfahrzeug - den "Shuttle" - und senkrecht zu der Lagerebene davon getrennt durch eine Hubstation oder einen Aufzug außerhalb der Gasse gefördert. Als Transportboxen kommen in einem erfindungsgemäßen Shuttlelager insbesondere als Carrier, HA200, SMIF oder FOUP bezeichnete Standardbehälter in Betracht.

Die Montage der Haltekonstruktion an der Raumdecke ist durch die nivellierbaren Halteelemente von der Ausrichtung und Montage der Lagerplätze und Transportwege konstruktiv getrennt. Das erfindungsgemäße Shuttlelager erleichtert und beschleunigt gleichermaßen Beschaffung, Bevorratung, Planung und Montage.

Vorzugsweise sind in einem erfindungsgemäßen Shuttlelager die Halteelemente in Längsrichtung der Gasse in einem Rastermaß beabstandet. Die Rasterung erlaubt eine Standardisierung der Planung und Herstellung des Shuttlelagers.

Vorzugsweise sind die Lagerplätze eines solchen erfindungsgemäßen Shuttlelagers in Lagergruppen vormontiert, die in einer Längsrichtung der Gasse ein Rastermaß oder ein Vielfaches, vorzugsweise ein zwei- oder dreifaches des Rastermaßes aufweisen. Weiter vorzugsweise weisen Bodengruppen, die das Shuttlelager unten abschließen, ein entsprechendes Maß auf.

Vormontierte Baugruppen beschleunigen die Montage des erfindungsgemäßen Shuttlelagers und reduzieren so insbesondere die Stillstandszeiten von bestehenden Fertigungsumgebungen unterhalb der Lagerebene. Darüber hinaus ist die Lagerhaltung durch die reduzierte Anzahl unterschiedlicher Komponenten für die Herstellung des Shuttlelagers vereinfacht.

Weiter vorzugsweise weist ein solches erfindungsgemäßes Shuttlelager Start- und Endmodule mit einer einseitigen Begrenzung der Gasse und ein Übergabemodul mit der Übergabestation auf. Diese Modularisierung vereinfacht die Planung des erfindungsgemäßen Shuttlelagers.

Die Verwendung von Modulen und Baugruppen in einem einheitlichen Rastermaß erhöht einerseits die Flexibilität in der Anpassung des erfindungsgemäßen Shuttlelagers an unterschiedliche räumliche Anforderungen und vermindert zudem wiederum die Anzahl unterschiedlicher Komponenten und damit den Aufwand der Lagerhaltung.

Vorzugsweise weisen die Deckenelemente eines solchen erfindungsgemäßen Shuttlelagers je zwei an der Gasse einander gegenüber angeordnete Halteelemente und vorzugsweise ein horizontal verlaufendes Stabilisierungselement zwischen den Halteelementen 13 auf. Die Befestigung zwischen einander gegenüber angeordneten Halteelementen 13 vermeidet ein Verkippen von Lagerplätzen und Transportweg quer zu der Gasse. Das Stabilisierungselement vereinfacht die Montage der einander gegenüber angeordneten Halteelemente an der Raumdecke im gewünschten Abstand.

Vorzugsweise weist ein erfindungsgemäßes Shuttlelager einen Linearmotor für das Lagerfahrzeug auf. Weiter vorzugsweise befindet sich der Linearmotor auf dem Boden der Gasse. Das Lagerfahrzeug wird weiter vorzugsweise induktiv mit Energie versorgt. Gegenüber alternativ möglichen Antrieben durch Riemenachsen oder Zahnstangen sowie der alternativ möglichen Energieversorgung über Kabel und Kabelketten oder Schleifkontakte vermeidet ein solches erfindungsgemäßes Shuttlelager insbesondere unter Reinraumbedingungen Abrieb und Partikelemission auf die Wafer.

Vorzugsweise weist ein erfindungsgemäßes Shuttlelager einen gitterförmig ausgebildeten Boden der Gasse auf. Weiter vorzugsweise weist ein solches erfindungsgemäßes Shuttlelager parallel zu der Gasse angeordnete Außenwände auf. Beides vermeidet Eingriffe von Außen in die Lagerplätze und Transportwege des Shuttlelagers und ermöglicht dennoch eine laminare vertikale Durchströmung von Lagerplätzen und Transportweg von oben nach unten, um eine Kontamination der Waferscheiben zu vermeiden.

Vorzugsweise sind in einem erfindungsgemäßen Shuttlelager die Lagerplätze in zwei Reihen beidseits der Gasse angeordnet. Die Kapazität des erfindungsgemäßen Shuttlelagers wird so verdoppelt.

Ein erfindungsgemäßes Shuttlelager kann mehrere Übergabestationen aufweisen, mehrere erfindungsgemäße Shuttlelager über- und/oder nebeneinander können zu einer Lagereinrichtung kombiniert werden.

Ausgehend von dem bekannten Verfahren wird erfindungsgemäß vorgeschlagen, dass an der Raumdecke eine Haltekonstruktion befestigt wird und in einer horizontal verlaufenden Lagerebene in die Haltekonstruktion vormontierte Module eingehängt werden, die das Shuttlelager bilden. Das erfindungsgemäße Verfahren erlaubt die Herstellung eines erfindungsgemäßen Shuttlelagers und zeichnet sich gleichermaßen durch dessen vorstehend beschriebene Vorteile aus.

Vorzugsweise werden im Rahmen eines erfindungsgemäßen Verfahrens nach Befestigen der Haltekonstruktion an der Raumdecke Halteelemente der Haltekonstruktion in einer vertikalen Höhe in die Lagerebene nivelliert. Nach Befestigen der Haltekonstruktion an der Raumdecke können die Halteelemente besonders einfach mit Hilfe eines Nivellierlasergeräts nivelliert werden. Wenn die Module erst anschließend montiert werden, stören sie das Nivellieren nicht.

Das erfindungsgemäße Shuttlelager ermöglicht eine Gasse mit einem einzelnen Lagerfahrzeug bis zu einer Länge von 48 m.

### Ausführungsbeispiel

Die Erfindung wird nachfolgend anhand eines Ausführungsbeispiels erläutert. Es zeigen
- Fig. 1: ein erfindungsgemäßes Shuttlelager,
- Fig. 2: ein Deckenelement des Shuttlelagers,
- Fig. 3: einen Profilquerschnitt und
- Fig. 4: ein Detail des Deckenelements,
- Fig. 5: ein Endmodul des Shuttlelagers,
- Fig. 6: ein dreifaches Modul des Shuttlelagers,
- Fig. 7: ein Übergabemodul des Shuttlelagers und
- Fig. 8: ein einfaches Modul des Shuttlelagers.

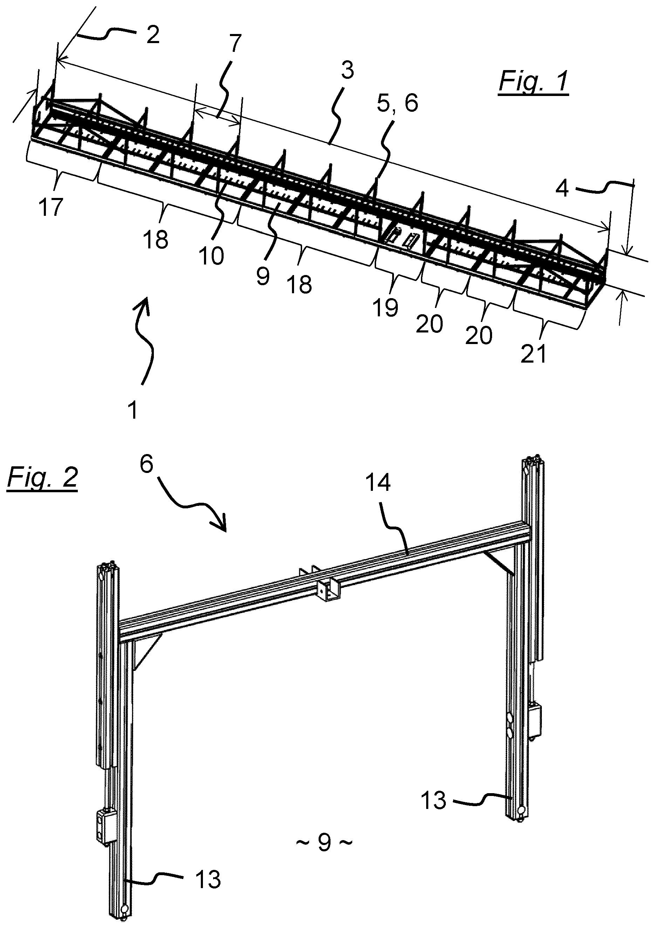

Das in Figur 1 gezeigte erfindungsgemäße Shuttlelager 1 weist eine Breite 2 von 124 cm, eine Länge 3 von 1446 cm, und eine Höhe 4 von 90 cm auf und befindet sich in einem nicht dargestellten Reinraum zur Halbleiterverarbeitung unter einer unebenen Raumdecke.

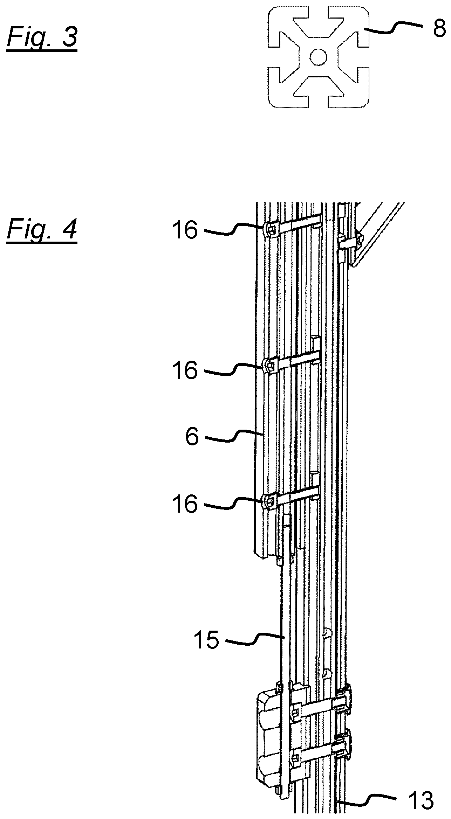

Zur Herstellung des Shuttlelagers 1 wird zunächst eine Haltekonstruktion 5 mit in Figur 2 gezeigten Deckenelementen 6 im Abstand eines Rastermaßes 7 von 120 cm an der Raumdecke befestigt. Die Deckenelemente 6 bestehen im Wesentlichen aus einem T-Nut-Aluminiumprofil mit einem in Figur 3 gezeigten quadratischen Querschnitt 8 von 40 x 40 mm.

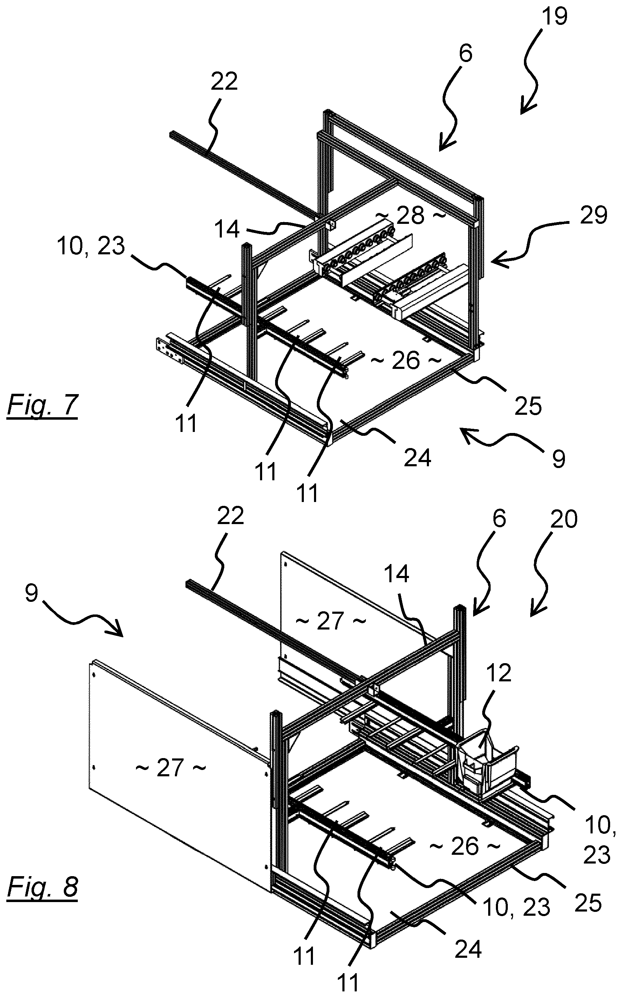

Beidseits einer horizontal verlaufenden Gasse 9 weist das Shuttlelager 1 zwei Reihen 10 mit zusammen achtzig Lagerplätzen 11 für (beispielhaft erst in Figur 8 dargestellte) Transportboxen 12 auf. Die Transportboxen 12 sind standardisierte offene Behälter für bis zu 25 Waferscheiben mit einem Durchmesser von 200 mm auf.

Jedes der Deckenelemente 6 weist jeweils beidseits der Gasse 9 zwei Halteelemente 13 auf, die U-förmig quer zu der Gasse 9 mit einem Stabilisierungselement 14 verbunden sind. Die Halteelemente 13 werden nach Befestigung an der Raumdecke mittels eines Gewindestabs 15 an den Deckenelementen 6 in einem Verstellbereich von 10 cm vertikal auf Höhe einer nicht dargestellten Lagerebene mittels Lasersystemen (Waage und Linie) nivelliert, um die Unebenheiten der Raumdecke auszugleichen und in der jeweils gewählten Position mittels drei Klemmschrauben 16 fixiert.

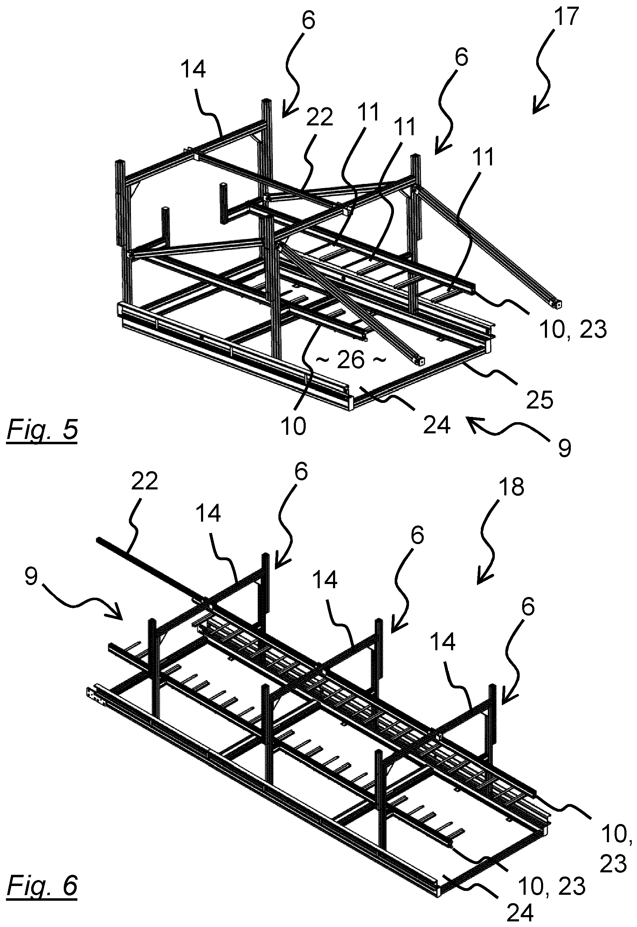

In der Projektierung wurde das Shuttlelager 1 aus fünf standardisierten Modulen aufgebaut, nämlich einem Startmodul 17, zwei Dreifachmodulen 18, einem Übergabemodul 19, zwei Einfachmodulen 20 und einem Endmodul. Das Startmodul 17, das Dreifachmodul 18, das Übergabemodul 19 und das Einfachmodul 20 sind in den Figuren 5 bis 8 isoliert dargestellt.

Die Module für die Projektierung umfassen jeweils die zugehörigen Deckenelemente 6, Aufnahmen 22 für die Spannungsversorgung zwischen den Deckenelementen 6 in Längsrichtung der Gasse 9, eine oder mehrere Lagergruppen 23, eine Bodengruppe 24 mit einem Rahmen 25 aus dem genannten Aluminiumprofil und einem darin eingelegten gitterförmig ausgebildeten Bodenelement 26 und (vereinfachend nur in Figur 8 dargestellte) Seitenwände 27 auf. Das Endmodul 21 entspricht spiegelbildlich dem Startmodul 17, umfasst aber abweichend zwei zusätzliche Seitenwände 27 und eine zusätzliche Aufnahme 22 für die Spannungsversorgung entlang der Gasse 9.

Das Einfachmodul 20 und das Übergabemodul 19 weist entlang der Gasse 9 das einfache Rastermaß 7, das Dreifachmodul 18 das dreifache Rastermaß 7, das Startmodul 17 und das Endmodul 21 weist das eineinhalbfache Rastermaß 7 auf. Das Übergabemodul 19 weist eine Lagergruppe 23 und dieser gegenüber eine Öffnung 28 für die in Figur 7 angedeutete Übergabestation 29 auf. Alle anderen Module weisen je zwei entlang der Gasse 9 einander gegenüber angeordnete Lagergruppen 23 auf. Jede Lagergruppe 23 weist je Rastermaß 7 vier Lagerplätze auf.

Zur Montage des Shuttlelagers 1 werden nach der Nivellierung zunächst die Aufnahmen 22 für die Spannungsversorgung entlang der Gasse 9, dann die vormontierten Lagergruppen 23 und Bodengruppen 24 und die Seitenwände 27 an den Halteelementen 13 und zuletzt ein nicht dargestellter Linearmotor für das Lagerfahrzeug entlang der Gasse 9 auf den Bodengruppen 24 angebracht und am Übergabemodul 19 eine nicht dargestellte Hubstation mit der Übergabestation 29 bereitgestellt.

Das nicht dargestellte Lagerfahrzeug wird über einen Stromabnehmer aus den Aufnahmen 22 für die Spannungsversorgung induktiv mit Energie versorgt.

Der Schutzbereich des europäischen Patents wird durch die Patentansprüche bestimmt.

In den Figuren sind
- 1: Shuttlelager
- 2: Breite
- 3: Länge
- 4: Höhe
- 5: Haltekonstruktion
- 6: Deckenelement
- 7: Rastermaß
- 8: Querschnitt
- 9: Gasse
- 10: Reihe
- 11: Lagerplatz
- 12: Transportbox
- 13: Halteelement
- 14: Stabilisierungselement
- 15: Gewindestab
- 16: Klemmschraube
- 17: Startmodul
- 18: Dreifachmodul
- 19: Übergabemodul
- 20: Einfachmodul
- 21: Endmodul
- 22: Aufnahme für die Spannungsversorgung
- 23: Lagergruppe
- 24: Bodengruppe
- 25: Rahmen
- 26: Bodenelement
- 27: Seitenwand
- 28: Öffnung
- 29: Übergabestation

## Patentansprüche

1. Shuttlelager (1) für Transportboxen (12) für Waferscheiben
• mit einer horizontal verlaufenden Gasse (9) für ein Lagerfahrzeug,
• mit einem Linearmotor für das Lagerfahrzeug auf einem Boden der Gasse (9),
• mit einer Übergabestation (29) zur Übergabe der Transportboxen (12) in das oder aus dem Shuttlelager (1),
• mit einer Haltekonstruktion (5), die von einer Raumdecke abgehängt ist und
• mit Lagerplätzen (11) für die Transportboxen (12), die in einer horizontal verlaufenden Lagerebene entlang der Gasse (9) an der Haltekonstruktion (5) befestigt sind,
und mit an der Raumdecke befestigten Deckenelementen (6), und an den Deckenelementen (6) in einer vertikalen Höhe nivellierbar angebrachte Halteelemente (13) für die Lagerplätze (11), wobei zum Herstellen des Shuttlelagers (1) zunächst die Deckenelemente (6) an der Raumdecke befestigt und die Halteelemente (13) für die Lagerplätze in einer vertikalen Höhe in der Lagerebene nivelliert und dann die Lagerplätze an den Halteelementen (13) befestigt werden.

2. Shuttlelager (1) nach dem vorgenannten Anspruch, ***dadurch gekennzeichnet, dass*** die Halteelemente (13) in Längsrichtung der Gasse (9) in einem Rastermaß (7) beabstandet sind.

3. Shuttlelager (1) nach dem vorgenannten Anspruch, ***gekennzeichnet durch*** vormontierte Lagergruppen (23) mit den Lagerplätzen (11) und/oder das Shuttlelager (1) unten abschließenden Bodengruppen (24), die in der Längsrichtung das Rastermaß (7) oder ein Vielfaches, vorzugsweise ein zwei- oder dreifaches des Rastermaßes (7) aufweisen.

4. Shuttlelager (1) nach einem der Ansprüche 2 oder 3, ***gekennzeichnet durch*** ein Startmodul (17) und ein Endmodul (21) mit einer einseitigen Begrenzung der Gasse (9) und mindestens ein Übergabemodul (19) mit der Übergabestation (29).

5. Shuttlelager (1) nach einem der vorgenannten Ansprüche, ***dadurch gekennzeichnet, dass*** die Deckenelemente (6) je zwei an der Gasse (9) einander gegenüber angeordnete Halteelemente (13) und vorzugsweise ein horizontal verlaufendes Stabilisierungselement (14) zwischen den Halteelementen (13) aufweisen.

6. Shuttlelager (1) nach einem der vorgenannten Ansprüche, ***gekennzeichnet durch*** einen gitterförmig ausgebildeten Boden der Gasse (9) und vorzugsweise parallel zu der Gasse (9) angeordnete Außenwände.

7. Shuttlelager (1) nach einem der vorgenannten Ansprüche, ***dadurch gekennzeichnet, dass*** die Lagerplätze in zwei Reihen (10) beidseits der Gasse (9) angeordnet sind.

8. Verfahren zum Herstellen eines Shuttlelagers (1) für Transportboxen (12) für Waferscheiben mit einer horizontal verlaufenden Gasse (9) für ein Lagerfahrzeug, mit einem Linearmotor für das Lagerfahrzeug auf einem Boden der Gasse (9), mit einer Übergabestation (29) zur Übergabe der Transportboxen (12) in das oder aus dem Shuttlelager (1), mit einer Haltekonstruktion (5), die von einer Raumdecke abgehängt ist und mit Lagerplätzen (11) für die Transportboxen (12) in einer horizontal verlaufenden Lagerebene entlang der Gasse (9) an der Haltekonstruktion (5), ***dadurch gekennzeichnet, dass*** zunächst Deckenelemente (6) an der Raumdecke befestigt und Halteelemente (13) für die Lagerplätze in einer vertikalen Höhe in der Lagerebene nivelliert und dann die Lagerplätze an den Halteelementen (13) befestigt werden.

## Claims

1. A shuttle storage (1) for transport boxes (12) for wafer discs, the shuttle storage comprising:
a horizontal drive alley (9) for a storage vehicle;
a linear motor (30) for the storage vehicle, the linear motor arranged on a floor of the drive alley (9);
a transfer station (29) configured to transfer the transport boxes (12) into or from the shuttle storage (1);
a support structure (5) that is suspended from a room ceiling;
storage spaces (11) for the transfer boxes (12), wherein the storage spaces are attached at the support structure (5) in a horizontally extending storage plane along the drive alley (9); and
ceiling elements (6) attached at the room ceiling, and support elements (13) for the storage spaces (11), wherein the support elements (13) are attached at the ceiling elements (6) so that the support elements are adjustable with respect to vertical height,
wherein the ceiling elements (6) are initially attached at the room ceiling, the support elements (13) for the storage spaces are adjusted with respect to vertical height in the storage plane, and thereafter the storage spaces are attached at the support elements (13).

2. The shuttle storage (1) according to claim 1, **characterized in that** the support elements (13) are offset from one another in a longitudinal direction of the drive alley (9) by a grid spacing (7).

3. The shuttle storage (1) according to claim 2, **characterized by** preassembled storage groups (23) including the storage spaces (11) and/or floor groups (24) that terminate the shuttle storage (1) at a bottom, wherein the floor groups are offset from one another by the grid spacing (7) in the longitudinal direction or by 2x or 3x the grid spacing (7).

4. The shuttle storage (1) according to one of the claims 2 or 3, **characterized by** a start module (17) and an end module (21) including a one-sided boundary of the drive alley (9) and at least one transfer module (19) including the transfer station (29).

5. The shuttle storage (1) according to one of the preceding claims, **characterized in that** the ceiling elements (6) respectively include two support element (13) arranged on opposite sides of the drive alley (9) and a horizontal stabilization element (14) arranged between the support elements (13).

6. The shuttle storage (1) according to one of the preceding claims, **characterized by** a grid shaped floor of the drive alley (9) and outer walls arranged parallel to the drive alley (9).

7. The shuttle storage (1) according to one of the preceding claims, **characterized in that** the storage spaces are arranged in two rows (10) with one row of the two rows arranged on each side of the drive alley (9).

8. A method for producing a shuttle storage (1) for transport boxes (12) for wafer discs, the shuttle storage including
a horizontal drive alley (9) for a storage vehicle,
a linear motor (30) for the storage vehicle, the linear motor arranged on a floor of the drive alley (9),
a transfer station (29) configured to transfer the transport boxes (12) into or from the shuttle storage (1),
a support structure (5) that is suspended from a room ceiling,
storage spaces (11) for the transfer boxes (12), wherein the storage spaces are attached at the support structure (5) in a horizontally extending storage plane along the drive alley (9),
**characterized by**
initially attaching ceiling elements (6) at the room ceiling; thereafter
attaching support elements (13) at the ceiling elements (6); thereafter
leveling the support elements (13) for the storage spaces (11) with respect to vertical height in the storage plane; and thereafter
attaching the storage spaces at the support elements (13).

## Revendications

1. Système d'entreposage à navette (1) pour bacs de transport (12) pour des plaquettes de semi-conducteurs
• avec une travée passant horizontalement (9) pour un véhicule d'entreposage,
• avec un moteur linéaire pour le véhicule d'entreposage sur un fond de travée (9),
• avec un poste de transfert (29) pour le transfert des bacs de transport (12) dans le ou du système d'entreposage à navette (1),
• avec une structure de maintien (5), qui est suspendue d'un plafond de local, et
• avec des emplacements d'entreposage (11) pour les bacs de transport (12), qui sont fixés le long de la travée (9) sur la structure de maintien (5) dans un plan d'entreposage passant horizontalement,
et avec des éléments de plafond (6) fixés au plafond de local et des éléments de maintien (13) placés pouvant être mis à niveau sur les éléments de plafond (6) à une hauteur verticale pour les emplacements d'entreposage (11),
sachant que pour fabriquer le système d'entreposage à navette (1) les éléments de plafond (6) sont d'abord fixés au plafond de local et les éléments de maintien (13) pour les emplacements d'entreposage sont mis à niveau à une hauteur verticale dans le plan d'entreposage et les emplacements d'entreposage sont fixés ensuite aux éléments de maintien (13).

2. Système d'entreposage à navette (1) selon la revendication précédente, ***caractérisé* en ce que** les éléments de maintien (13) sont espacés d'une mesure d'emboîtement (7) dans le sens longitudinal de la travée (9).

3. Système d'entreposage à navette (1) selon la revendication précédente, ***caractérisé par*** des groupes d'entreposage prémontés (23) avec les emplacements d'entreposage (11) et/ou le système d'entreposage à navette (1) en dessous des groupes de fond de finalisation (24), qui comportent dans le sens longitudinal la mesure d'emboîtement (7) ou un multiple, de préférence le double ou le triple de la mesure d'emboîtement (7).

4. Système d'entreposage à navette (1) selon l'une quelconque des revendications 2 ou 3, ***caractérisé par*** un module de départ (17) et un module final (21) avec une délimitation unilatérale de la travée (9) et au moins un module de transfert (19) avec le poste de transfert (29).

5. Système d'entreposage à navette (1) selon l'une quelconque des revendications précédentes, ***caractérisé* en ce que** les éléments de plafond (6) comportent entre les éléments de maintien (13) respectivement deux éléments de maintien (13) disposés opposés l'un à l'autre sur la travée (9) et de préférence un élément de stabilisation (14) passant horizontalement.

6. Système d'entreposage à navette (1) selon l'une quelconque des revendications précédentes, ***caractérisé* par** un fond constitué en forme de grillage de la travée (9) et des parois extérieures disposées de préférence parallèlement à la travée (9).

7. Système d'entreposage à navette (1) selon l'une quelconque des revendications précédentes, ***caractérisé en ce que*** les emplacements d'entreposage sont disposés en deux rangées (10) des deux côtés de la travée (9).

8. Procédé de fabrication d'un système d'entreposage à navette (1) pour bacs de transport (12) pour des plaquettes de semi-conducteurs avec une travée passant horizontalement (9) pour un véhicule d'entreposage, avec un moteur linéaire pour le véhicule d'entreposage sur un fond de travée (9) avec un poste de transfert (29) pour le transfert des bacs de transport (12) dans le ou du système d'entreposage à navette (1), avec une structure de maintien (5), qui est suspendue d'un plafond de local et avec des emplacements d'entreposage (11) pour les bacs de transport (12) dans un plan d'entreposage passant horizontalement le long de la travée (9) sur la structure de maintien (5), ***caractérisé* en ce que** les éléments de plafond (6) sont fixés d'abord au plafond de local et les éléments de maintien (13) pour les emplacements d'entreposage sont mis à niveau à une hauteur verticale dans le plan d'entreposage et les emplacements d'entreposage sont ensuite fixés aux éléments de maintien (13).
